# EUROPEAN PATENT SPECIFICATION

(11) **EP 3 385 741 B1**
(45) Date of publication and mention of the grant of the patent: **18.12.2019**
(21) Application number: 17290053.2
(22) Date of filing: 07.04.2017
(51) Int. Cl.: G01R 33/09

(54) **MAGNETIC SENSOR CELL FOR MEASURING ONE- AND TWO-DIMENSIONAL MAGNETIC FIELDS AND METHOD FOR MEASURING SAID MAGNETIC FIELDS USING THE MAGNETIC SENSOR CELL**
MAGNETISCHE SENSORZELLE ZUR MESSUNG EIN- UND ZWEIDIMENSIONALER MAGNETFELDER UND VERFAHREN ZUR MESSUNG BESAGTER MAGNETFELDER MIT DER MAGNETISCHEN SENSORZELLE
CELLULE DE CAPTEUR MAGNÉTIQUE PERMETTANT DE MESURER DES CHAMPS MAGNÉTIQUES À UNE OU DEUX DIMENSIONS ET PROCÉDÉ DE MESURE DESDITS CHAMPS MAGNÉTIQUES À L'AIDE DE LA CELLULE DE CAPTEUR MAGNÉTIQUE

(43) Date of publication of application: 10.10.2018
(73) Proprietor: Crocus Technology S.A., 38025 Grenoble Cedex (FR)
(72) Inventor: Childress, Jeffrey, San Jose, CA 95120 (US); Foissac, Romain, 38000 Grenoble (FR); Mackay, Kenneth, 38700 Le Sappey en Chartreuse (FR)
(74) Representative: P&TS SA (AG, Ltd.)

(56) References cited:
- WO-A1-2008/020817
- US-A1- 2003 184 919
- US-A1- 2004 109 264
- US-A1- 2005 207 070
- US-A1- 2007 228 501
- US-A1- 2014 292 318
- US-A1- 2015 137 292
- US-A1- 2016 252 591

## Description

### Field

The present disclosure concerns a magnetic sensor cell having a magnetic tunnel junction that can sense one- and two-dimensional magnetic fields. The present disclosure also pertains to a method for sensing the one- and two-dimensional external magnetic field using the magnetic sensor cell.

### Description of related art

Self-referenced magnetic tunnel junctions can be used to sense magnetic fields, in magnetic sensors or compasses. Self-referenced magnetic tunnel junctions typically comprise a reference layer having a reference magnetization, a sense layer having a sense magnetization and a tunnel barrier layer between the sense layer and the reference layer. During a sensing operation, an external magnetic field aligns the sense magnetization more parallel or more antiparallel to the reference magnetization.

Ideally, the sense layer should have a linear and non-hysteretic behavior with respect to the applied field, when measured along the pinned reference layer direction. The linear sensing is usually achieved by having the sense magnetization being perpendicular to the reference magnetization. This can be achieved by pinning the reference magnetization perpendicular to the anisotropy axis of the sense layer. The anisotropy axis of the sense layer lies parallel to the plane of the sense and reference layers.

When an external field is applied, self-referenced magnetic tunnel junctions thus allow for measuring the component of the magnetic field along the magnetization axis of the reference layers. By utilizing two junctions, or two arrays of junctions found in MLU devices, i.e. two arrays of self-referenced magnetic tunnel junctions, with reference layers oriented 90 degrees from each other, the two components of the magnetic field in the plane of the two reference layers can be measured.

WO2008020817 discloses a read head is which includes a first layer structure having a pinned ferromagnetic layer, a first spacer layer and a second layer structure including a synthetic anti-ferromagnetic (SAF) multi-layer structure. The SAF multi-layer structure includes a first ferromagnetic free layer, a second ferromagnetic free layer, and a second spacer layer arranged in between the two ferromagnetic layers. A first magnetization of the first ferromagnetic free layer and a second magnetization of the second ferromagnetic layer are perpendicular to a fixed magnetization of the pinned ferromagnetic layer.

US2007228501 discloses magnetic recording element which includes a magnetic free layer whose magnetization is variable in accordance with a current direction passing through a film and whose direction of easy axis of magnetization is a direction perpendicular to a film plane, a magnetic pinned layer whose magnetization is fixed to a direction perpendicular to the film plane, and a non-magnetic barrier layer between the magnetic free layer and the magnetic pinned layer. In the magnetic free layer, a relation between a saturated magnetization Ms (emu/cc) and an anisotropy field Han (Oe) satisfies Han>12.57 Ms, and Han<1.2 E 7 MS<-1>+12.57 Ms.

US2015137292 discloses a nanoscale tunnel magneto-resistance (TMR) sensor comprising an in-plane-magnetized reference layer and a free layer comprising interfacial perpendicular anisotropy, wherein the free layer comprises a sensing layer for sensing resistance as a function of applied magnetic field and is tunable to vary the direction of the sensing layer magnetization to be in-plane, canted, or out-of-plane.

US2016252591 a method for sensing an external magnetic field using a magnetic sensor cell including: a magnetic tunnel junction including a reference layer having a reference magnetization oriented parallel to the plane of the reference layer, a sense layer having a sense magnetization, and a tunnel barrier layer between the sense and reference layers. A field line is configured for passing a field current for providing a sense magnetic field adapted for aligning the sense magnetization. The sense layer magnetization is orientable between a direction parallel to the plane of the sense layer and a direction perpendicular to the plane of the sense layer when the sense magnetic field is provided. The external magnetic field includes an in-plane component oriented parallel to the plane of the sense layer and an out-of-plane component perpendicular to the plane of the sense layer. The method includes sensing the out-of-plane component; and sensing the in-plane component.

US2014292318 discloses a magnetic biosensor which includes a magnetic stack comprising a free layer, a fixed layer, and a nonmagnetic layer between the free layer and the fixed layer. At least one of the free layer or the fixed layer may have a magnetic moment oriented out of a major plane of the free layer or the fixed layer, respectively, in an absence of an external magnetic field. The magnetic biosensor also may include a sample container disposed over the magnetic stack, a plurality of capture antibodies attached to a bottom surface of the sample container above the magnetic stack, and a magnetic field generator configured to generate a magnetic field substantially perpendicular to the major plane of the free layer or fixed layer.

US2005207070 discloses a magnetically-coupled structure which has two ferromagnetic layers with their in-plane magnetization directions coupled orthogonally across an electrically-conducting spacer layer that induces the direct orthogonal magnetic coupling. The structure has application for in-stack biasing in a current-perpendicular-to-the-plane (CPP) magnetoresistive sensor. One of the ferromagnetic layers of the structure is a biasing ferromagnetic layer and the other ferromagnetic layer is the sensor free layer. An antiferromagnetic layer exchange-couples the biasing layer to fix its moment parallel to the moment of the sensor pinned layer.

### Summary

The present disclosure concerns a magnetic sensor cell comprising a magnetic tunnel junction comprising a reference layer having a reference magnetization oriented substantially parallel to the plane of the reference layer, a sense layer having a sense magnetization, and a tunnel barrier layer between the sense and reference layers; the sense layer comprising an intrinsic anisotropy being substantially perpendicular to the plane of the sense layer such that the sense magnetization is orientable between an initial direction perpendicular to the plane of the sense layer and a direction parallel to the plane of the sense layer; the intrinsic anisotropy having in anisotropy field being above 150 Oe, and wherein a thickness of the tunnel barrier layer is between 1 nm and 3 nm, such that a tunnel magnetoresistance of the magnetic tunnel junction is higher than 50%.

The present disclosure further concerns method for sensing a one-dimensional and two-dimensional external magnetic field using the magnetic sensor cell; the method comprising:
pinning the reference magnetization such that it does not move in the external magnetic field;
subjecting the magnetic sensor cell to the external magnetic field; and
measuring a resistance of the magnetic sensor cell.

An advantage of the magnetic sensor cell is that the sense magnetization is always aligned perpendicular to the reference magnetization in the absence of magnetic field.

### Brief Description of the Drawings

The disclosure will be better understood with the aid of the description of an embodiment given by way of example and illustrated by the figures, in which:
Fig. 1 represents a cross section view (a) and a top view (b) of a magnetic sensor cell comprising a magnetic tunnel junction with a sense layer having a sense magnetization, according to an embodiment;
Fig. 2 shows the sense layer according, to an embodiment;
Fig. 3 illustrates an enlarged portion of the magnetic tunnel junction, according to an embodiment; and
Fig. 4 shows a top view of the magnetic tunnel junction, according to an embodiment.

### Detailed Description of possible embodiments

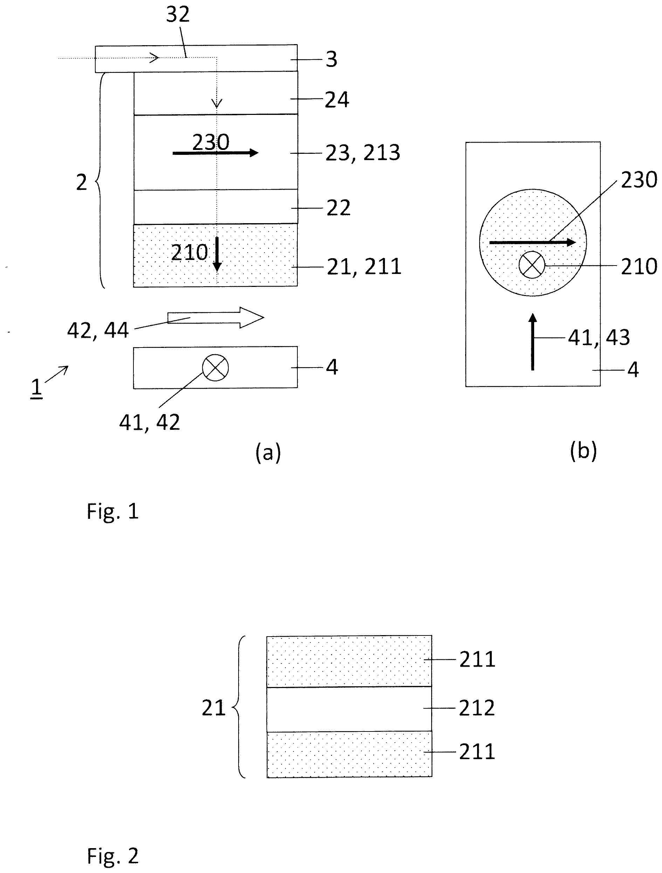

Fig. 1 represents a cross section view (Fig. 1a) and a top view (Fig. 1b) of a magnetic sensor cell 1 according to an embodiment. The magnetic sensor cell 1 comprises a magnetic tunnel junction 2 including a reference layer 23 having a reference magnetization 230, a sense layer 21 having a sense magnetization 210 and a tunnel barrier layer 22 between the sense layer 21 and the reference layer 23. A current line 3 is in electrical contact with one extremity of the magnetic tunnel junction 2. The magnetic sensor cell 1 further comprises a field line 4 adapted for passing a sense field current 41 or a reference field current 43 such as to generate, respectively, a sense magnetic field 42 and a reference magnetic field 44. The reference magnetization 230 and the sense magnetization 210 can be oriented substantially parallel to the plane of the reference and sense layers 21, 23.

In an embodiment, the sense layer 21 comprises an out-of-plane intrinsic anisotropy. The intrinsic anisotropy is oriented substantially perpendicularly to the plane of the sense layer 21. The anisotropy field represents the approximate magnetic field required to overcome this anisotropy and orient the sense magnetization 210 in the plane of the sense layer 21.

Preferably, the out-of-plane intrinsic anisotropy of the sense layer 21 has an anisotropy field that is above 150Oe. More generally, the anisotropy field should be greater than the minimal magnitude of an external magnetic field required for rotating (or switching) the sense magnetization 210. Thus, the anisotropy field depends on the application, i.e., the magnitude of the external magnetic field to be sensed. For example, the anisotropy field can be above 160Oe, or above 180Oe.

In an embodiment, in the absence of a magnetic field, the sense magnetization 210 is initially oriented substantially out-of-plane (see Fig. 1). In this configuration, the sense magnetization 210 is orientable between its initial out-of-plane direction and a direction substantially parallel to the plane of the sense layer 21 (in-plane) when an external magnetic field 45 is applied in a direction in-plane.

The linear sensing is usually achieved by having the sense magnetization 210 being perpendicular to the reference magnetization 230. This can be achieved by pinning the reference magnetization 230 perpendicular to the anisotropy axis of the sense layer 21. The anisotropy axis of the sense layer 21 lies parallel to the plane of the sense and reference layers 21, 23.

In an embodiment, the sense layer 21 comprises a ferromagnetic layer 211 comprising a CoₓFe_{y}B_{z} alloy.

Thickness of the sense layer 21 can be varied in order to change the net perpendicular anisotropy value, i.e., the magnitude of the anisotropy field. The sense layer 21 can have a thickness between 0.5 nm and 2 nm.

Preferably the ferromagnetic layer 211 comprises a Co₂₀Fe₆₀B₂₀ alloy, wherein the content is in at%. A thickness of the sense layer 21 of about 1.5 nm then yields a anisotropy field above 150 Oe, or above 160Oe, or above 180Oe.

In a variant illustrated in Fig. 2, the sense layer 21 comprises a multilayer configuration comprising at least the ferromagnetic layer 211 and a non-magnetic layer 212. The non-magnetic layer 212 can comprise any one or a combination of these elements: Ta, W, Mo, Nb, Zr, Ti, MgO, Hf. The non-magnetic layer 212 can promote perpendicular anisotropy at CoFeB interfaces of the sense layer 21.

In this configuration, each of the non-magnetic layer 212 can have a thickness comprised between 0.1 nm and 0.4 nm.

The reference layer 23 can comprise one or a plurality of ferromagnetic layers 213, each ferromagnetic layer 213 comprising Co, Fe, Ni, CoFeB or their alloys. The reference layer 23 can further comprise a synthetic antiferromagnet (SAF) comprising at least two of the ferromagnetic layer 213, two ferromagnetic layers 213 being separated by an antiparallel coupling layer comprising of of: Ru, Ir or Cu or a combination of these elements. In an exemplary embodiment, the reference layer 23 comprises the following arrangement: CoFe(2.5nm) / Ru(0.8nm) / CoFe(1nm) / CoFeB(2nm).

The tunnel barrier 22 can comprise, or be formed of, an insulating material. Suitable insulating materials include oxides, such as aluminum oxide (e.g., Al2O3) and magnesium oxide (e.g., MgO). The oxidation state of the oxide can be adjusted to increase the perpendicular anisotropy field of the sense layer 21. A thickness of the tunnel barrier layer 22 can be in the nm range, such as from about 1 nm to about 3 nm. An optimal thickness of the tunnel barrier 22 can achieves both perpendicular anisotropy field above 150Oe, or above 160Oe, or above 180Oe, while providing a tunnel magnetoresistance (TMR) of the magnetic tunnel junction 2 being higher than 50% preferably 100%. An optimal thickness of the tunnel barrier 22 can be obtained by inserting a plurality (double or multilayer) of MgO (or another suitable oxide or insulating material) layers.

In a preferred embodiment, the insulating materials is MgO and the thickness is about 1 nm.

In another variant not represented, another insulating material layer is added in direct contact with the sense layer 21, on the side of thesense layer 21 opposed to the one in contact with the tunnel barrier layer 22 . This additional insulating material layer allows for increasing the anisotropy field and thus allowing for thicker sense layer 21 while keeping high enough anisotropy field. Thicker sense layer 21 allows for obtaining a more robust magnetic layer and signal-noise ratio improvement of the magnetic sensor cell 1. The additional insulating material layer is preferably a MgO layer.

Using the additional insulating material layer allows the sense layer to have a thickness between 1 to 3 nm, for example, 2 nm.

In normal operating conditions of the magnetic sensor cell 1, the reference magnetization 230 is fixed in the presence of an external magnetic field 45 while the sense magnetization 210 can be aligned in that field.

To that end, the magnetic sensor cell 1 can comprise an antiferromagnetic layer 24 exchange coupling the reference layer 23 such as to pin the reference magnetization 230 at a low temperature threshold T_{L} and free it at a high temperature threshold T_{H}.

Suitable materials for the antiferromagnetic layer 24 include transition metals and their alloys. For example, suitable antiferromagnetic materials include alloys based on manganese (Mn), such as alloys based on iridium (Ir) and Mn (e.g., IrMn); alloys based on Fe and Mn (e.g., FeMn); alloys based on platinum (Pt) and Mn (e.g., PtMn); and alloys based on Ni and Mn (e.g., NiMn). In some instances, the high temperature threshold T_{H}, of alloys based on Ir and Mn (or based on Fe and Mn) can be in the range of about 120°C to about 220°C or about 150°C to about 200°C, such as about 200°C, and can be smaller than the high temperature threshold T_{H} of alloys based on Pt and Mn (or based on Ni and Mn), which can be in the range of about 300°C to about 350°C. Suitable materials for the antiferromagnetic layer 24 can further include oxide layers, such as NiO.

In a preferred embodiment, the antiferromagnetic layer 24 comprises a IrMn layer having of about 10 nm in thickness.

In an embodiment, the magnetic tunnel junction 2 comprises, in this order, a Si substrate, an underlayer, the antiferromagnetic layer 24, the reference layer 23, the tunnel barrier layer 22, the sense layer 21 and at least a cap layer.

The underlayer can comprise a multilayer comprising one or more of: Ta, TaN, Ti, TiN, W, Cu, CuN, Ru, Cr, NiFe, Pt, Nb, Mo, Ir. In a possible embodiment, the underlayer comprises the following arrangement: Ta(5nm) / Ru(2nm).

The magnetic sensor cell 1 can be programmed by switching the reference magnetization 230 in a predetermined direction in the plane of the reference layer 23 (see Fig. 1b). The programming operation can be thermally assisted wherein the programming operation further comprises a step of heating the magnetic tunnel junction 2 to the high temperature threshold T_{H} by passing a heating current 31 in the magnetic tunnel junction 2 via the current line 3. The reference magnetization 230 is then switched by applying the reference magnetic field 44. After switching the reference magnetization 230, the magnetic tunnel junction 2 can be cooled to the low temperature threshold such as to pin the reference magnetization 230 in the switched state. The reference magnetic field 44 is generated by passing the reference field current 43 in the field line 4 with a direction being determined by the polarity of the reference field current 43.

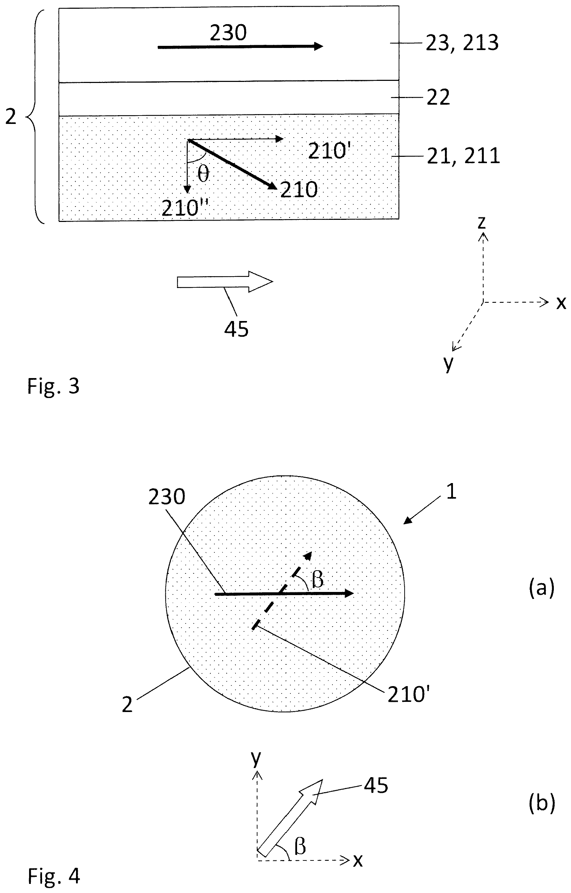

Fig. 3 illustrates an enlarged portion of the magnetic tunnel junction 2 of the magnetic sensor cell 1 of Fig. 1, showing the reference layer 23, tunnel barrier layer 22 and sense layer 21, in the presence of an external magnetic field 45 that is oriented in-plane. Also shown in Fig. 3 is x, y, z coordinates, wherein the x, y coordinates are in-plane, i.e., in the plane of the sense layer 21 (and of the reference layer 23).

Depending on its magnitude, the in-plane external magnetic field 45 (or an in-plane component of an external magnetic field) deflects the sense magnetization 210 from its initial orientation out-of-plane to an deflected orientation at an angle θ between the 0° (out-of-plane) to 90° (in-plane). For a non-zero angle smaller than 90°, the sense magnetization 210 comprises an in-plane component 210' and an out-of-plane component 210". For an angle of than 90°, the sense magnetization 210 comprises only an-plane component 210'.

In an embodiment, sensing the magnitude of the in-plane external magnetic field 45 with magnetic sensor cell 1 can be performed by measuring a resistance R of the magnetic tunnel junction 2 when the sense magnetization 210 is deflected by the in-plane external magnetic field 45.

Measuring a resistance R of the magnetic tunnel junction 2 can be performed by passing a sense current 32 in the magnetic tunnel junction 2 via the current line 3. The measured a resistance R is proportional to the relative magnitude of the reference magnetization 230 and the in-plane component 210' of the sense magnetization 210. The measured a resistance R is also proportional to the orientation, in the plane of the sense layer (and reference layer), of the in-plane component 210' of the sense magnetization 210 relative to the reference magnetization 230.

Fig. 4a shows a top view of the magnetic tunnel junction 2 where the reference magnetization 230 and the in-plane component 210' of the sense magnetization 210 are visible. In particular, Fig. 4 illustrates the case where the in-plane external magnetic field 45 is oriented at an angle β relative to the orientation of the reference magnetization 230 (see Fig. 4b).

The magnetic sensor cell 1 disclosed herein can thus be used for sensing (or measuring) the magnitude of the component along the reference-layer axis, i.e., along the plane of the reference layer 23, of an in-plane external magnetic field 45 oriented in-plane (unidimensional, or 1D, applications).

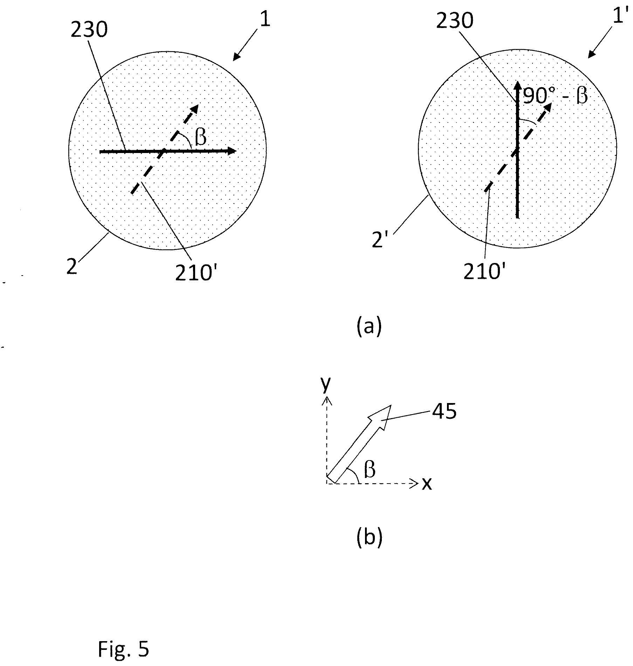

In an embodiment represented in Fig. 5, the magnetic sensor cell 1 comprises two magnetic tunnel junctions 2, wherein the storage magnetization 230 of one of the magnetic tunnel junctions 2 is aligned substantially at 90° relative to the storage magnetization 230 of the other magnetic tunnel junction 2. Fig. 5a shows a top view of the two magnetic tunnel junctions 2 and Fig. 5b shows the in-plane external magnetic field 45 oriented at an angle β to the orientation of the reference magnetization 230 of one of the magnetic tunnel junctions 2 (and at an angle 90°-β to the orientation of the reference magnetization 230 of the other magnetic tunnel junction 2). By using two separate magnetic tunnel junctions 2 with reference layer axes oriented 90-degrees from each other, the two orthogonal in-plane components of the external magnetic field 45 can be measured for sensing the in-plane orientation β of the in-plane external magnetic field 45 (two-dimensional, or 2D, applications).

Here one-dimensional and two-dimensional refer to an external magnetic field 45 being oriented along, respectively one and two dimensions in a Cartesian coordinate system.

More generally, the magnetic sensor cell 1 can comprise a first array and a second array, each array comprising a plurality of the magnetic tunnel junction 2 (not shown). The magnetic tunnel junctions 2 of the first array and the magnetic tunnel junctions 2 of the second array can have their respective (pinned) storage magnetization 230 aligned substantially at 90° from each other.

Sensing the two orthogonal in-plane components of the external magnetic field 45 can be performed by measuring the resistance R of each of the first and second array.

The in-plane component 201' of the sense magnetization 210 sense layer 21 having a strong perpendicular anisotropy has a very small (near-zero) coercivity and very small in-plane anisotropy. The in-plane component 201' has a good linearity and non-hysteretic behavior over a wide magnitude range of the in-plane external field 45. The magnetic sensor cell 1 disclosed herein is thus advantageous over conventional magnetic sensor cells for sensing an in-plane external field 45 and for 1D and 2D angular applications.

### Reference numbers and symbols

- 1: magnetic sensor cell
- 2: magnetic tunnel junction
- 21: sense layer
- 210: sense magnetization
- 201': in-plane component of the sense magnetization
- 201": out-of-plane component of the sense magnetization
- 211: ferromagnetic layer
- 212: non-magnetic layer
- 22: tunnel barrier layer
- 23: reference layer
- 230: reference magnetization
- 24: antiferromagnetic layer
- 3: current line
- 31: heating current
- 32: sense current
- 4: field line
- 41: sense field current
- 42: sense magnetic field
- 43: reference field current
- 44: reference magnetic field
- 45: external magnetic field
- R: resistance of the magnetic tunnel junction
- θ: angle
- β: angle

## Claims

1. Magnetic sensor cell (1) comprising
a magnetic tunnel junction (2) comprising a reference layer (23) having a reference magnetization (230) oriented substantially parallel to the plane of the reference layer (23), a sense layer (21) having a sense magnetization (210), and a tunnel barrier layer (22) between the sense and reference layers (21, 23);
the sense layer (21) comprising an intrinsic anisotropy being substantially perpendicular to the plane of the sense layer (21) such that the sense magnetization (210) is orientable between an initial direction perpendicular to the plane of the sense layer (21) and a direction parallel to the plane of the sense layer (21);
**characterized in that**,
the intrinsic anisotropy has an anisotropy field being above 150 Oe; and
**in that** a thickness of the tunnel barrier layer (22) is between 1 nm and 3 nm, such that a tunnel magnetoresistance of the magnetic tunnel junction (2) is higher than 50%.

2. The magnetic sensor cell according to claim 1,
wherein the sense layer (21) comprises a ferromagnetic layer (211) comprising a CoₓFe_{y}B_{z} alloy.

3. The magnetic sensor cell according to claim 2,
wherein the ferromagnetic layer (211) comprises Co₂₀Fe₆₀B₂₀.

4. The magnetic sensor cell according to claim 2 or 3,
wherein the ferromagnetic layer (211) has a thickness between 0.5 nm and 2 nm.

5. The magnetic sensor cell according to claim 4,
wherein the ferromagnetic layer (211) has a thickness of 1.5 nm.

6. The magnetic sensor cell according to any one of claims 2 to 5,
wherein the sense layer (21) comprises a multilayer configuration comprising at least the ferromagnetic layer (211) and a non-magnetic layer (212).

7. The magnetic sensor cell according to claim 6,
wherein the non-magnetic layer (212) comprises any one or a combination of these elements: Ta, W, Mo, Nb, Zr, Ti, MgO, Hf.

8. The magnetic sensor cell according to claim 6 or 7,
wherein the non-magnetic layer (212) has a thickness between 0.1 nm and 0.4 nm.

9. The magnetic sensor cell according to any one of claims 1 to 8, the insulating materials is MgO and the thickness is about 1 nm.

10. The magnetic sensor cell according to any one of claims 1 to 9, comprising a first array and a second array, each array comprising a plurality of the magnetic tunnel junction (2), wherein the magnetic tunnel junctions (2) of the first array and the magnetic tunnel junctions (2) of the second array have their storage magnetization (230) aligned substantially at 90° from each other.

11. A method for sensing a one-dimensional and two-dimensional external magnetic field (45) using the magnetic sensor cell (1) according to any one of claims 1 to 10, wherein the sense magnetization (210) is initially oriented perpendicular to the plane of the sense layer (21); the method comprising:
pinning the reference magnetization (230) such that it does not move in the external magnetic field (45);
subjecting the magnetic sensor cell (1) to the external magnetic field (45); and
measuring a resistance (R) of the magnetic sensor cell (1).

12. The method according to claim 11,
wherein said measuring a resistance (R) is performed by passing a sense current (32) in the magnetic tunnel junction (2).

13. The method according to claim 11 or 12,
wherein the resistance (R) is proportional to a component (210') of the sense magnetization (210) being oriented parallel to the plane of the sense layer (21).

14. The method according to any one of claims 11 to 13,
wherein the resistance (R) is proportional to an angle (β) between a component (210') of the sense magnetization (210) being oriented parallel to the plane of the sense layer (21) relative to the orientation of the reference magnetization (230).

15. The method according to any one of claims 11 to 14,
wherein the magnetic sensor cell comprises a first array and a second array, each array comprising a plurality of the magnetic tunnel junction (2), wherein the magnetic tunnel junctions (2) of the first array and the magnetic tunnel junctions (2) of the second array have their storage magnetization (230) aligned substantially at 90° from each other; and wherein the method comprises measuring the two orthogonal in-plane components of the external magnetic field (45) by measuring a resistance (R) of each of the first and second array.

## Patentansprüche

1. Magnetsensorzelle (1), umfassend
einen Magnettunnelübergang (2), umfassend eine Referenzschicht (23) mit einer Referenzmagnetisierung (230), die im Wesentlichen parallel zur Ebene der Referenzschicht (23) orientiert ist, eine Erfassungsschicht (21) mit einer Erfassungsmagnetisierung (210), und eine Tunnelbarriereschicht (22) zwischen der Erfassungs- und der Referenzschicht (21, 23);
die Erfassungsschicht (21), umfassend eine intrinsische Anisotropie, die im Wesentlichen senkrecht zur Ebene der Erfassungsschicht (21) ist, so dass die Erfassungsmagnetisierung (210) zwischen einer Anfangsrichtung senkrecht zur Ebene der Erfassungsschicht (21) und einer Richtung parallel zur Ebene der Erfassungsschicht (21) orientierbar ist;
**dadurch gekennzeichnet, dass**
die intrinsische Anisotropie ein Anisotropiefeld aufweist, das über 150 Oe liegt; und
dass eine Dicke der Tunnelbarriereschicht (22) zwischen 1 nm und 3 nm liegt, so dass ein Tunnelmagnetowiderstand des Magnettunnelübergangs (2) höher als 50 % ist.

2. Magnetsensorzelle nach Anspruch 1,
wobei die Erfassungsschicht (21) eine ferromagnetische Schicht (211), umfassend eine CoₓFe_{y}B_{z}-Legierung, umfasst.

3. Magnetsensorzelle nach Anspruch 2,
wobei die ferromagnetische Schicht (211) Co₂₀Fe₆₀B₂₀ umfasst.

4. Magnetsensorzelle nach Anspruch 2 oder 3,
wobei die ferromagnetische Schicht (211) eine Dicke zwischen 0,5 nm und 2 nm aufweist.

5. Magnetsensorzelle nach Anspruch 4,
wobei die ferromagnetische Schicht (211) eine Dicke von 1,5 nm aufweist.

6. Magnetsensorzelle nach einem der Ansprüche 2 bis 5,
wobei die Erfassungsschicht (21) eine Mehrschichtkonfiguration, umfassend wenigstens die ferromagnetische Schicht (211) und eine nichtmagnetische Schicht (212), umfasst.

7. Magnetsensorzelle nach Anspruch 6,
wobei die nichtmagnetische Schicht (212) eines oder eine Kombination dieser Elemente umfasst: Ta, W, Mo, Nb, Zr, Ti, MgO, Hf.

8. Magnetsensorzelle nach Anspruch 6 oder 7,
wobei die nichtmagnetische Schicht (212) eine Dicke zwischen 0,1 nm und 0,4 nm aufweist.

9. Magnetsensorzelle nach einem der Ansprüche 1 bis 8, wobei das Isoliermaterial MgO ist und die Dicke etwa 1 nm beträgt.

10. Magnetsensorzelle nach einem der Ansprüche 1 bis 9, umfassend eine erste Anordnung und eine zweite Anordnung, wobei jede Anordnung eine Vielzahl der Magnettunnelübergänge (2) umfasst, wobei die Magnettunnelübergänge (2) der ersten Anordnung und die Magnettunnelübergänge (2) der zweiten Anordnung ihre Speichermagnetisierung (230) im Wesentlichen um 90° zueinander ausgerichtet haben.

11. Verfahren zum Erfassen eines eindimensionalen und zweidimensionalen externen Magnetfelds (45) unter Verwendung der Magnetsensorzelle (1) nach einem der Ansprüche 1 bis 10, wobei die Erfassungsmagnetisierung (210) anfänglich senkrecht zur Ebene der Erfassungsschicht (21) orientiert ist; das Verfahren umfassend:
Pinnen der Referenzmagnetisierung (230), so dass sie sich nicht im externen Magnetfeld (45) bewegt;
Aussetzen der Magnetsensorzelle (1) dem externen Magnetfeld (45); und
Messen eines Widerstands (R) der Magnetsensorzelle (1).

12. Verfahren nach Anspruch 11,
wobei das Messen eines Widerstands (R) durchgeführt wird, indem ein Erfassungsstrom (32) in den Magnettunnelübergang (2) geleitet wird.

13. Verfahren nach Anspruch 11 oder 12,
wobei der Widerstand (R) proportional zu einer Komponente (210') der Erfassungsmagnetisierung (210) ist, die parallel zur Ebene der Erfassungsschicht (21) orientiert ist.

14. Verfahren nach einem der Ansprüche 11 bis 13,
wobei der Widerstand (R) proportional zu einem Winkel (β) zwischen einer Komponente (210') der Erfassungsmagnetisierung (210) ist, die parallel zur Ebene der Erfassungsschicht (21) relativ zur Orientierung der Referenzmagnetisierung (230) orientiert ist.

15. Verfahren nach einem der Ansprüche 11 bis 14,
wobei die Magnetsensorzelle umfasst eine erste Anordnung und eine zweite Anordnung, wobei jede Anordnung eine Vielzahl der Magnettunnelübergänge (2) umfasst,wobei die Magnettunnelübergänge (2) der ersten Anordnung und die Magnettunnelübergänge (2) der zweiten Anordnung ihre Speichermagnetisierung (230) im Wesentlichen um 90° zueinander ausgerichtet haben; und
wobei das Verfahren das Messen der zwei orthogonalen Komponenten in der Ebene des externen Magnetfelds (45) durch Messen eines Widerstands (R) von jeder der ersten und der zweiten Anordnung umfasst.

## Revendications

1. Cellule de capteur magnétique (1) comprenant
une jonction tunnel magnétique (2) comprenant une couche de référence (23) ayant une magnétisation de référence (230) orientée de manière sensiblement parallèle au plan de la couche de référence (23), une couche de détection (21) ayant une magnétisation de détection (210) et une couche barrière tunnel (22) entre les couches de détection et de référence (21, 23) ;
la couche de détection (21) comprenant une anisotropie intrinsèque qui est sensiblement perpendiculaire au plan de la couche de détection (21) de telle sorte que la magnétisation de détection (210) puisse être orientée entre une direction initiale perpendiculaire au plan de la couche de détection (21) et une direction parallèle au plan de la couche de détection (21) ;
**caractérisée en ce que**
l'anisotropie intrinsèque comporte un champ d'anisotropie qui est supérieur à 150 Oe ; et
**en ce qu'**une épaisseur de la couche barrière tunnel (22) est comprise entre 1 nm et 3 nm de telle sorte qu'une magnétorésistance de tunnel de la jonction tunnel magnétique (2) soit supérieure à 50 %.

2. Cellule de capteur magnétique selon la revendication 1,
dans laquelle la couche de détection (21) comprend une couche ferromagnétique (211) comprenant un alliage de CoₓFe_{y}B_{z}.

3. Cellule de capteur magnétique selon la revendication 2,
dans laquelle la couche ferromagnétique (211) comprend du Co₂₀Fe₆₀B₂₀.

4. Cellule de capteur magnétique selon la revendication 2 ou 3,
dans laquelle la couche ferromagnétique (211) présente une épaisseur comprise entre 0,5 nm et 2 nm.

5. Cellule de capteur magnétique selon la revendication 4,
dans laquelle la couche ferromagnétique (211) présente une épaisseur de 1,5 nm.

6. Cellule de capteur magnétique selon l'une quelconque des revendications 2 à 5,
dans laquelle la couche de détection (21) comprend une configuration multicouche comprenant au moins la couche ferromagnétique (211) et une couche non magnétique (212).

7. Cellule de capteur magnétique selon la revendication 6,
dans laquelle la couche non magnétique (212) comprend l'un quelconque de ces éléments ou une combinaison de ces derniers : le tantale (Ta), le tungstène (W), le molybdène (Mo), le niobium (Nb), le zirconium (Zr), le titane (Ti), l'oxyde de magnésium (MgO), le hafnium (Hf).

8. Cellule de capteur magnétique selon la revendication 6 ou 7,
dans laquelle la couche non magnétique (212) présente une épaisseur comprise entre 0,1 nm et 0,4 nm.

9. Cellule de capteur magnétique selon l'une quelconque des revendications 1 à 8, le matériau isolant étant l'oxyde de magnésium (MgO) et l'épaisseur étant d'environ 1 nm.

10. Cellule de capteur magnétique selon l'une quelconque des revendications 1 à 9, comprenant un premier réseau et un second réseau, chaque réseau comprenant une pluralité de jonctions tunnels magnétiques (2), dans laquelle les jonctions tunnels magnétiques (2) du premier réseau et les jonctions tunnels magnétiques (2) du second réseau ont leur magnétisation de stockage (230) alignée sensiblement à 90° l'une par rapport à l'autre.

11. Procédé pour détecter un champ magnétique externe unidimensionnel ou bidimensionnel (45) à l'aide de la cellule de capteur magnétique (1) selon l'une quelconque des revendications 1 à 10, dans lequel la magnétisation de détection (210) est initialement orientée de manière perpendiculaire au plan de la couche de détection (21) ; le procédé comprenant :
bloquer la magnétisation de référence (230) de telle sorte qu'elle ne se déplace pas dans le champ magnétique externe (45) ;
soumettre la cellule de capteur magnétique (1) au champ magnétique externe (45) ; et
mesurer une résistance (R) de la cellule de capteur magnétique (1).

12. Procédé selon la revendication 11,
dans lequel ladite mesure d'une résistance (R) est effectuée en passant un courant de détection (32) dans la jonction tunnel magnétique (2).

13. Procédé selon la revendication 11 ou 12,
dans lequel la résistance (R) est proportionnelle à un composant (210') de la magnétisation de détection (210) qui est orientée de manière parallèle au plan de la couche de détection (21).

14. Procédé selon l'une quelconque des revendications 11 à 13,
dans lequel la résistance (R) est proportionnelle à un angle (β) entre un composant (210') de la magnétisation de détection (210) qui est orientée de manière parallèle au plan de la couche de détection (21) par rapport à l'orientation de la magnétisation de référence (230).

15. Procédé selon l'une quelconque des revendications 11 à 14,
dans lequel la cellule de capteur magnétique comprend un premier réseau et un second réseau, chaque réseau comprenant une pluralité de jonctions tunnels magnétiques (2), dans lequel les jonctions tunnels magnétiques (2) du premier réseau et les jonctions tunnels magnétiques (2) du second réseau ont leur magnétisation de stockage (230) alignée sensiblement à 90° l'une par rapport à l'autre ; et
dans lequel le procédé consiste à mesurer les deux composants dans le plan orthogonal du champ magnétique externe (45) en mesurant une résistance (R) de chacun du premier et du second réseau.
